Europäisches Patentamt

European Patent Office

Office européen des brevets

(11) Veröffentlichungsnummer: **0 457 306 A2**

# EUROPÄISCHE PATENTANMELDUNG

(21) Anmeldenummer: 91107872.3

(51) Int. Cl.5: **G08C 23/00**

(22) Anmeldetag: **15.05.91**

(30) Priorität: **18.05.90 DE 4016010**

(43) Veröffentlichungstag der Anmeldung:
**21.11.91 Patentblatt 91/47**

(84) Benannte Vertragsstaaten:
**AT BE CH DE DK ES FR GB GR IT LI LU NL SE**

(71) Anmelder: **GAS-, ELEKTRIZITÄTS- UND WASSERWERKE KÖLN AG.**
**Parkgürtel 24**
**W-5000 Köln 30(DE)**

(72) Erfinder: **Woelki, Peter, Dipl.-Ing.**
**Mechernicher Weg 25**
**W-5042 Erftstadt(DE)**

(74) Vertreter: **Koepsell, Helmut, Dipl.-Ing.**
**Mittelstrasse 7**
**W-5000 Köln 1(DE)**

(54) Verfahren zum Auslesen und/oder Einlesen von Daten an einem mikroprozessorgesteuerten Datenspeicher, insbesondere eines registrierenden Mess- oder Zählgerätes sowie Einrichtung zur Durchführung des Verfahrens.

(57) Ein Verfahren zum Auslesen und/oder Einlesen von Daten an einem mikroprozessorgesteuerten Datenspeicher, insbesondere eines registrierenden Meß- oder Zählgerätes sowie eine Einrichtung zur Durchführung des Verfahrens. Die Daten werden zwischen einem Datenspeicher (2) und einer Ein-Auslesevorrichtung (7) über eine Schnittstelle mit drahtloser Signalverbindung übertragen. Die Schnittstelle wird durch räumliche Annäherung eines mit der Ein-Auslesevorrichtung (7) verbundenen optischen Abtastkopfes (4) an einen mit dem Datenspeicher (2) verbundenen optischen Sendekopf (3) zur Erzielung eines optischen Signalweges gebildet. Die zum Auslesen von Daten auf der Seite des Datenspeichers (2) notwendige elektrische Energie wird angesteuert von der Ein-Auslesevorrichtung (7) aus als Hochfrequenzsignal in einem Sender (6) erzeugt und über eine am optischen Abtastkopf (4) angeordnete Induktionsspule (4.1) auf eine am optischen Sendekopf (3) angeordnete Induktionsspule (3.1) übertragen. Aus dem gleichgerichteten Hochfrequenzsignal wird die Speisespannung für den Betrieb der Schnittstelle des Datenspeichers (2) erzeugt.

FIG.1

Die Erfindung betrifft ein Verfahren zum Auslesen und/oder Einlesen von Daten an einem mikroprozessorgesteuerten Datenspeicher, insbesondere eines registrierenden Meß- oder Zählgerätes, bei dem die Daten zwischen dem Datenspeicher und einer Ein- Auslesevorrichtung über eine Schnittstelle mit drahtloser Signalverbindung übertragen werden.

Bei bestimmten registrierenden Meß- oder Zählgeräten, insbesondere bei Verbrauchszählern für Fernwärme, Gas und Wasser, aber auch beispielsweise bei der Datenerfassung von Umweltschutzstationen, ergibt sich die Aufgabe, daß die im Zähler gespeicherten Verbrauchsdaten in vorgegebenen Zeitabständen abgelesen werden müssen. Es ist bereits bekanntgeworden, anstelle der umständlichen Ablesung eines Zählerstandes durch eine Person mit dem notwendigen Eintragen des abgelesenen Zählerstandes von Hand ein automatisches Verfahren einzusetzen, mit dem bei Zählern, die einen mikropozessorgesteuerten Datenspeicher enthalten, die Daten über eine Schnittstelle mit drahtloser Signalverbindung direkt auf eine Ein- Auslesevorrichtung übertragen werden. Eine bekannte Einrichtung hierzu enthält einen an elektronische Auswerte- und Eingabeeinheiten angeschlossenen optischen Abtastkopf mit optoelektronischen Wandlern zur Abgabe und Aufnahme von optischen Signalen, während der Datenspeicher des Zählers mit einem entsprechenden optischen Sendekopf mit optoelektronischen Wandlern ausgerüstet ist und die Schnittstelle durch eine räumliche Annäherung von Abtastkopf und Sendekopf zur Erzielung eines optischen Signalweges gebildet wird. Die den Zähler ablesende Person braucht dann lediglich den optischen Abtastkopf einer mitgeführten tragbaren Ein-Auslesevorrichtung an eine vorgegebene Stelle an der Außenwand des Zählergehäuses anzusetzen, hinter der sich der Sendekopf befindet, und es können dann alle Daten automatisch übertragen werden. Ein hierbei auftretendes Problem besteht darin, daß das Auslesen von Daten in der oben beschriebenen Weise auf der Seite des Zählers einen Anteil an elektrischer Energie erfordert, der wesentlich größer ist als der im normalen Betrieb auftretende Energieanteil. Dies ist bei allen Zählern, die nicht, wie etwa Elektrizitätszähler, von Natur aus an eine elektrische Leitung angeschlossen sind, sondern, wie beispielsweise Zähler zur Fernwärmezählung oder zur Gaszählung, eine Batterie als elektrische Energiequelle besitzen, eine erhebliche Belastung dieser Batterie, die dazu führt, daß die Batterien relativ häufig ausgewechselt werden müssen. Dies ist insbesondere dann unerwünscht, wenn die Zeitabstände, in denen die Batterie ausgewechselt werden muß, kleiner sind als der Eichzeitraum des Zählers, da die Batterie sich innerhalb des plombierten Teils des Zählers befindet und jeder Eingriff in den Zähler während des Eichzeitraumes unerwünscht ist. Es wird daher angestrebt, daß die Lebensdauer der Batterie eines derartigen Zählers nach Möglichkeit mindestens so groß sein soll wie der Eichzeitraum.

Der Erfindung liegt die Aufgabe zugrunde, ein Verfahren der eingangs und im Oberbegriff des Patentanspruchs 1 angegebenen Art zu schaffen, mit dem es möglich ist, insbesondere das Auslesen von Daten in einer Weise durchzuführen, die die Spannungsquelle des mikroprozessorgesteuerten Datenspeichers nicht belastet. Weiterhin sollte eine Einrichtung zur Durchführung dieses Verfahrens geschaffen werden, die einfach aufgebaut und in sehr einfacher und sicherer Weise handhabbar ist.

Die Lösung dieser Aufgabe erfolgt erfindungsgemäß mit den Merkmalen aus dem kennzeichnenden Teil des Patentanspruchs 1. Vorteilhafte Ausführungsformen des erfindungsgemäßen Verfahrens sind in den Patentansprüchen 2 und 3 beschrieben.

Eine besonders vorteilhafte Einrichtung zur Durchführung des erfindungsgemäßen Verfahrens, bei der die Datenübertragung zwischen dem Datenspeicher und der Ein- Auslesevorrichtung über eine Schnittstelle mit einem optischen Signalweg erfolgt, ist in Patentanspruch 4 beschrieben. Vorteilhafte Ausführungsformen dieser Einrichtung sind Gegenstand der Patentansprüche 5 bis 7. Weitere Ausführungsbeispiele von Einrichtungen zur Durchführung des erfindungsgemäßen Verfahrens sind in den Ansprüchen 8 bis 12 beschrieben.

Der Grundgedanke der Erfindung besteht darin, nicht nur das Auslesen oder Einlesen von Daten zwischen Datenspeicher und Ein- und Auslesevorrichtung über eine Schnittstelle mit drahtloser Signalverbindung durchzuführen, sondern auch die insbesondere zum Auslesen erforderliche Energie drahtlos von außen, also von der Ein- Auslesevorrichtung her, zuzuführen. Auf diese Weise wird eine Belastung der Spannungsquelle des Datenspeichers während des Auslesevorgangs vermieden. Die Energiezuführung mittels eines Hochfrequenzsignals auf induktivem Wege hat sich hierbei als besonders einfach zu handhaben und vorteilhaft erwiesen. Insbesondere im Zusammenhang mit einer Einrichtung, bei der die Ein-Auslesevorrichtung einen optischen Abtastkopf besitzt und somit die Datenübertragung über einen optischen Weg erfolgt, führt das Verfahren mit induktiver Energieübertragung zu besonders einfachen und leicht zu handhabenden Einrichtungen. Hierbei ist es auch möglich, in mindestens einer Richtung über die drahtlose Energieverbindung auf induktivem Wege zusätzliche Daten durch entsprechende Modulation des Hochfrequenzsignals zu übertragen. Dies kann beispielsweise mittels eines frequenzmodulierten Trägersignals erfolgen. Auf diese Weise entsteht ohne Beeinflussung der Energieübertragung ein zusätzlicher Datenkanal, der von der optischen Übertragungsstrecke unabhängig ist. Die Schnittstelle kann nur in Betrieb genommen werden, wenn das Hochfrequenz-Trägersignal anliegt. Hierdurch wird ein zusätzlicher Schutz gegen eine unbefugte Datenmanipulation erzielt.

Selbstverständlich ist es aber auch möglich, das erfindungsgemäße Verfahren im Zusammenhang mit einer Datenübertragung auf rein induktivem Wege durchzuführen.

Das erfindungsgemäße Verfahren ist vor allem zum Ablesen von Wärmezählern, Gaszählern und dergleichen gedacht, es ist aber auch zum Ablesen von anderen extern ablesbaren Datenspeichern verwendbar und kann auch bei Zählern verwendet werden, die an eine eigene elektrische Energieversorgung angeschlossen sind. Letzteres hat den Vorteil, daß Ein- Auslesevorrichtungen geschaffen werden können, die bei sehr unterschiedlichen, mit genormten Ableseeinrichtungen versehenen Zählertypen verwendet werden können. Diese Art der drahtlosen Energiezuführung zum Auslesen von Daten hat den zusätzlichen Vorteil, daß durch das Annähern des Abtastkopfes der Ein-Auslesevorrichtung an den Sendekopf und dem damit verbundenen Anlegen der Betriebsspannung an die Ausleseeinheit des Datenspeichers bei einem Zählerprozessor ein sogenannter "Hardware-Interrupt" ausgelöst werden kann. Daraufhin beendet dieser Prozessor das Messen und führt die Datenkommunikation über die drahtlose Schnittstelle aus. Eine in bestimmten Zeitabständen wiederkehrende Unterbrechung der Messung,um zu kontrollieren, ob Informationen an der Schnittstelle anliegen, ist dadurch nicht mehr notwendig. Ebenso kann eine aufwendige Zeitsynchronisation zwischen Auslesegerät und Auslesezähler entfallen.

Die Anwendung des erfindungsgemäßen Verfahrens und der erfindungsgemäßen Einrichtungen ist aber nicht auf das Ablesen von Zählern beschränkt. Vielmehr kann auch die Dateneingabe in die Datenspeicher von registrierenden Meß- oder Zählgeräten mit Energiezuführung von außen über die drahtlose Schnittstelle durchgeführt werden, beispielsweise bei der Prüfung der Zählgeräte oder um bestimmte Steuerfunktionen auszuüben. Somit ist auch bei diesem stromintensiven Arbeiten eine Unterstützung der Batterie des Datenspeichers möglich.

Weiterhin ist das erfindungsgemäße Verfahren und die Einrichtungen hierzu nicht nur auf die Verwendung an Zählern beschränkt, sondern kann auch bei anderen mikroprozessorgesteuerten Datenspeichern verwendet werden, bei denen die Übertragung von Daten an eine externe Ein-Auslesevorrichtung über eine Schnittstelle mit drahtloser Signalverbindung erfolgt.

Das erfindungsgemäße Verfahren hat weiterhin den Vorteil, daß der mikroprozessorgesteuerte Datenspeicher bzw. der ganze diesen Datenspeicher enthaltende Zähler räumlich relativ weit von der Schnittstelle zur Datenübertragung entfernt sein kann, weil infolge des erfindungsgemäßen Verfahrens der Energiezuführung relativ große Leitungslängen zwischen der Schnittstelle und dem Datenspeicher in Kauf genommen werden können.

Bei einer Ausführungsform der erfindungsgemäßen Einrichtung, mit welcher sowohl die Energieübertragung als auch die Datenübertragung auf rein induktivem Wege durchgeführt wird, können am Abtastkopf und am Sendekopf jeweils mehrere Induktionsspulen konzentrisch ineinander angeordnet sein. Bei einer Anordnung von jeweils drei Induktionsspulen in dieser Weise werden drei voneinander unabhängige Übertragungskanäle erhalten, von denen einer zur Übertragung der Energie, ein weiterer zur Übertragung von Daten in einer Richtung und der dritte zur Übertragung von Daten in der Gegenrichtung ausgenutzt werden können. Andererseits ist es aber auch möglich, durch entsprechende schaltungstechnische Maßnahmen mehrere Übertragungskanäle mit einer Anzahl von Induktionsspulen zu erhalten, die kleiner ist als die Anzahl der Übertragungskanäle.

Im Folgenden wird anhand der beigefügten Zeichnungen ein Ausführungsbeispiel des erfindungsgemäßen Verfahrens und einer Einrichtung zur Durchführung des Verfahrens näher erläutert.

In den Zeichnungen zeigen:

Fig. 1    in einer stark schematisierten Darstellung einen Zähler mit einer daran angesetzten Ein- Auslesevorrichtung;

Fig. 2    in einem Blockschaltbild die wichtigsten Schaltelemente der Einrichtung nach Fig. 1, die zur drahtlosen Energieversorgung dienen;

Fig. 3    in einem Schaltbild die auf Seiten des Zählers notwendigen Schaltungseinrichtungen zur Energie- und Datenübertragung;

Fig. 4    in einer Darstellung analog Fig. 2 eine Variante der Einrichtung nach Fig. 1 mit zusätzlicher Datenübertragung auf induktivem Wege;

Fig. 5    in einer Darstellung analog Fig. 3 die auf Seiten des Zählers notwendigen Schaltungseinrichtungen bei der Variante nach Fig. 4.

Fig. 6    in einem Blockschaltbild die wichtigsten Schaltelemente einer Ein- Auslesevorrichtung in einer Ausführungsform mit nur induktiver Energie- und Datenübertragung;

Fig. 7 in einer Darstellung analog Fig. 6 eine Variante der Ausführungsform nach Fig. 6;

Fig. 8 in einer schematisierten perspektivischen Darstellung einen Abtastkopf für eine Einrichtung nach Fig. 7.

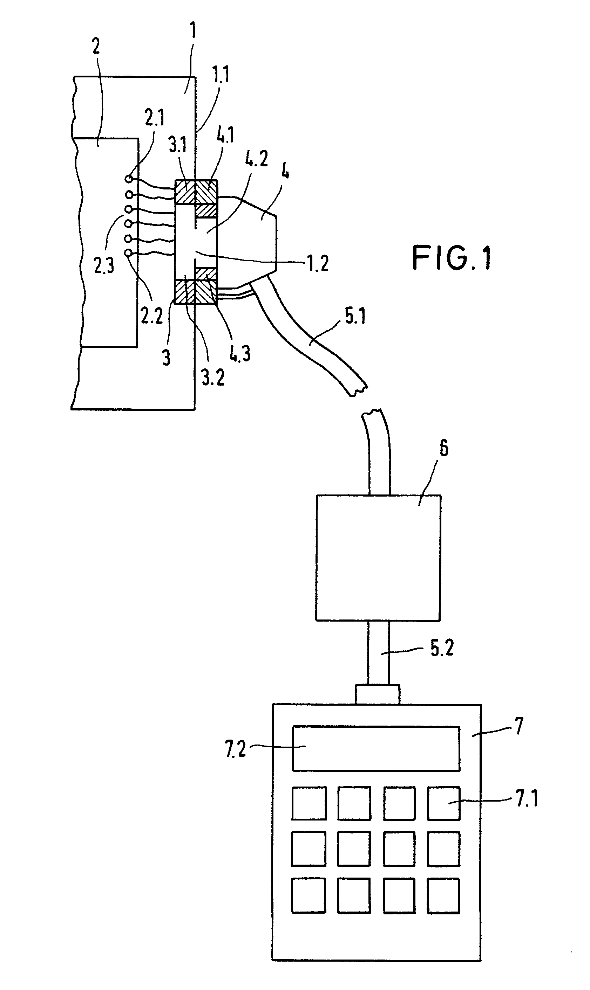

In Fig. 1 ist stark schematisiert ein Zähler beispielsweise zur Fernwärmezählung dargestellt, mit einem Gehäuse 1 und einem mikroprozessorgesteuerten Datenspeicher 2, welcher einen Speiseeingang 2.1, einen Datenausgang 2.2 und einen Dateneingang 2.3 aufweist. Die Ein-Ausgänge 2.1, 2.2 und 2.3 sind mit einem Bauteil 3 verbunden, das im folgenden als "Sendekopf" bezeichnet wird, obwohl über dieses Bauteil Daten in beiden Richtungen übertragen werden. Die Funktion dieses Sendekopfs 3 wird weiter unten näher erläutert. An die Außenseite der Gehäusewand 1.1 ist ein Bauteil 4 lösbar angesetzt, das im folgenden als "Abtastkopf" bezeichnet wird, obwohl durch dieses Bauteil ebenfalls Daten in beiden Richtungen übertragen werden können. Auch die Funktion dieses Bauteils wird weiter unten näher erläutert. Der Abtastkopf 4 besitzt an seiner Vorderseite einen Ringmagnet 4.3 mit dem erreicht wird, daß der auf die aus ferromagnetischem Material bestehende Gehäusewand 1.1 aufgesetzte Abtastkopf 4 dort haftet. Der Abtastkopf 4 ist über eine Leitung 5.1 mit einer Vorrichtung 6 verbunden, die in weiter unten näher beschriebener Weise einen Sender sowie Verstärker enthält. Er ist weiterhin über eine Leitung 5.2 mit einer Vorrichtung 7 verbunden, die Eingabe- und Auswerteeinheiten enthält und an ihrer Oberseite mit einer Tastatur 7.1 und einem Anzeigesichtfeld 7.2 versehen ist. Die Vorrichtungen 4, 6 und 7 bilden zusammen eine Ein-Auslesevorrichtung für den Datenspeicher 2 des Zählers. Die genauere Ausbildung der in der Vorrichtung 7 enthaltenen Auswerte- und Eingabeeinheiten wird im folgenden nicht dargestellt, weil es sich hier um an sich bekannte Schaltungen handelt. Die Übertragung von Daten zwischen dem Datenspeicher 2 und der Ein- Auslesevorrichtung 4-6-7 erfolgt in Richtung vom Datenspeicher 2 aus über den Sendekopf 3, der zu diesem Zweck ein Mittelteil 3.2 aufweist, welches optoelektronische Wandler enthält und dem ein Mittelteil 4.2 am Abtastkopf 4 gegenüberliegt, das entsprechend ebenfalls optoelektronische Wandler enthält, so daß durch eine Öffnung 1.2 in der Gehäusewand 1.1 ein drahtloser, optischer Signalweg zur Übertragung von Daten in beiden Richtungen gebildet wird.

Beim Auslesen von Daten aus dem Datenspeicher 2 wird von der Ein- Auslesevorrichtung aus die notwendige elektrische Energie auf den Datenspeicher 2 übertragen. Hierzu ist am Abtastkopf 4 eine dessen Vorderteil umgebende Induktionsspule 4.1 angeordnet, der an der Innenseite der Gehäusewand 1.1 eine das Mittelteil 3.2 des Sendekopfes 3 umgebende Induktionsspule 3.1 gegenüberliegt. Der Außendurchmesser des Vorderteils des Abtastkopfes 4 kann dabei im Bereich zwischen 25 bis 40mm liegen und beispielsweise 32 mm betragen. Entsprechend ist dann auch der Innendurchmesser der den Abtastkopf 4 umgebenden Induktionsspule 4.1 dimensioniert.

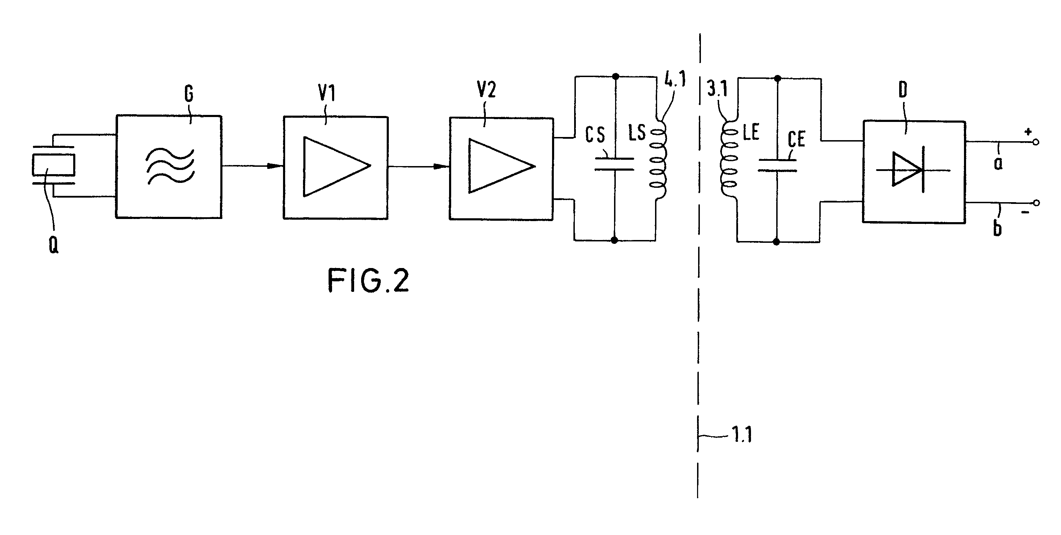

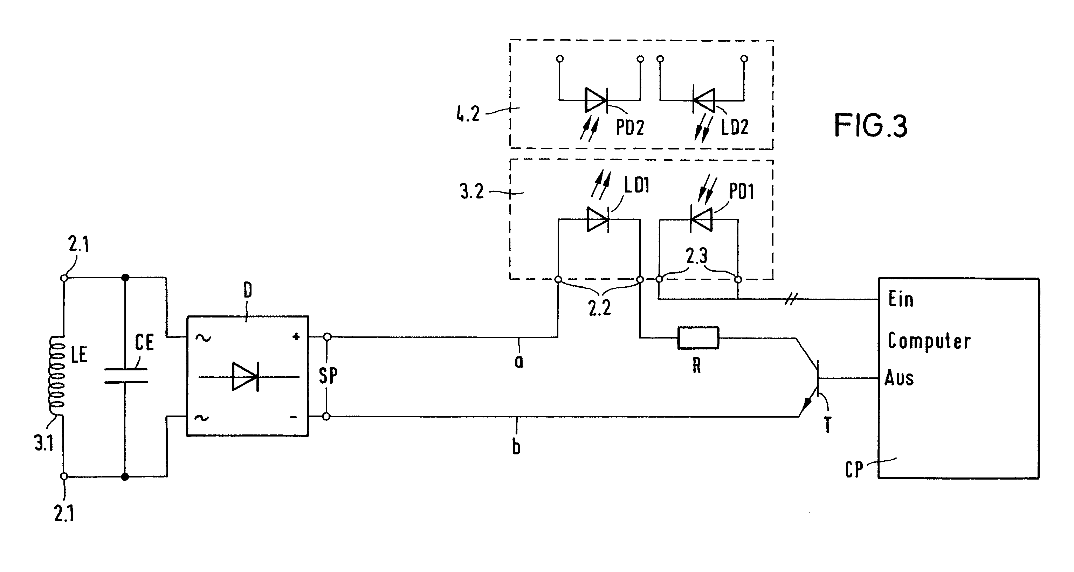

Die schaltungstechnischen Einzelheiten der Einrichtung zur Übertragung der elektrischen Energie über die Induktionsspulen 4.1 und 3.1 werden im folgenden anhand der Fig. 2 und 3 näher erläutert.

Fig. 2 zeigt auf der linken Seite die Schaltelemente, die der Ein- Auslesevorrichtung zugeordnet sind. Die Induktionsspule 4.1 im Abtastkopf 4, deren Induktivität mit LS bezeichnet ist, bildet zusammen mit einem Kondensator CS einen elektrischen Schwingkreis, der über einen Hauptverstärker V2 und einen Trennverstärker V1 an einen Oszillator G angeschlossen ist, der von einem Schwingquarz Q gesteuert wird. Die Bauteile CS, V2, V1, G und Q sind zweckmäßig innerhalb der Vorrichtung 6 von Fig. 1 angeordnet. Bei entsprechend kleiner Ausbildung der Schaltelemente (surface mounted device) können die Bauteile der Vorrichtung 6 innerhalb des optischen Abtastkopfes 4 angeordnet sein. Selbstverständlich ist es auch möglich, diese Bauelemente innerhalb der Vorrichtung 7 anzuordnen. Die der Induktionsspule 4.1 innerhalb des Gehäuses 1 gegenüberliegende Induktionsspule 3.1 bildet zusammen mit einem Kondensator CE ebenfalls einen elektrischen Schwingkreis, der auf die gleiche Frequenz abgestimmt ist wie der Schwingkreis LS-CS, nämlich auf die Frequenz von z.B. 32,7 kHz des Schwingquarzes Q. Der Schwingkreis LE-CE ist an einen Gleichrichter D angeschlossen, der an seinen Ausgängen SP, die gleichzeitig als die Speiseeingänge der Schnittstelle des Datenspeichers angesehen werden können, eine Gleichspannung an eine Leiterschleife a-b abgibt, deren Verlauf in Fig. 3 näher dargestellt ist.

Fig. 3 zeigt einen Mikrocomputer CP, der in nicht eigens dargestellter Weise einen Mikroprozessor sowie einen Datenspeicher enthält. Der Dateneingang ist an eine Fotodiode PD1 angeschlossen, die im Mittelteil 3.2 des Sendekopfes angeordnet ist. Der Datenausgang ist an die Basis eines Transistors T angeschlossen, der in der Leiterschleife a-b liegt, welche außerdem einen Widerstand R sowie eine im Mittelteil 3.2 des Sendekopfes angeordnete Lumineszenzdiode LD1 enthält. Das dem Mittelteil 3.2 des Sendekopfes gegenüberliegende Mittelteil 4.2 des Abtastkopfes 4 ist ebenfalls in Fig. 3 zu sehen und enthält entsprechend eine Fotodiode PD2 und eine Lumineszenzdiode LD2.

Wenn aus dem im Mikrocomputer CP enthaltenen Datenspeicher Daten ausgelesen werden sollen zur Zählerablesung, wird vom Oszillator G ein HF-Signal erzeugt, das nach Verstärkung in den Verstärkern V1 und V2 zum Auskoppelschwingkreis CS, LS gelangt und von der Induktionsspule 4.1 drahtlos weiter auf die Induktionsspule 3.1 und damit den Einkoppelschwingkreis LE-CE übertragen wird. Der Gleichrichter D gibt ein Gleichspannungssignal an die Leiterschleife a-b und damit die Betriebsspannung an den Transistor T, über den nunmehr die Daten ausgelesen werden, die von der Lumineszenzdiode LD1 auf optischem Wege auf die Fotodiode PD2 übertragen werden und in nicht eigens dargestellter Weise dann den in der Vorrichtung 7 angeordneten Auswerte- und Eingabeeinheiten zugeführt werden.

Diese Art der Energiezuführung zum Auslesen von Daten hat den zusätzlichen Vorteil, daß durch den Beginn der Zuführung der elektrischen Energie von außen und damit dem Anlegen der Speisespannung an den Transistor T vom Gleichrichter D aus, dem Mikrocomputer CP das Einschaltsignal zum Auslesen der Daten als "Hardware-Interrupt" gegeben werden kann und kein besonderes Einschaltsignal mehr zugeführt werden muß. Andererseits können aber in an sich bekannter Weise von den in der Vorrichtung 7 der Ein- Auslesevorrichtung angeordneten Auswerte- und Eingabeeinheiten aus Daten über die im Abtastkopf 4 angeordnete Lumineszenzdiode LD2 optisch auf die im Sendekopf 3 angeordnete Fotodiode PD1 übertragen und in den Datenspeicher eingelesen werden. Da eine Datenübertragung nur erfolgen kann, wenn über das Hochfrequenzsignal mit genau festgelegter Frequenz eine Energiezuführung erfolgt und die Speisespannung angelegt wird, ist ein Übertragen von Daten in der einen oder der anderen Richtung durch Unbefugte zumindest stark erschwert und somit ein weiterer Sicherheitsaspekt gegen unbefugtes Benutzen des Datenspeichers berücksichtigt.

In Fig. 1 sind Datenspeicher 2 und Sendekopf 3 als unmittelbar benachbart dargestellt. Diese Anordnung ist keinesfalls zwingend. Da das oben geschilderte Verfahren es zuläßt, ausreichend elektrische Energie von außen zuzuführen, können der Datenspeicher 2 und der Sendekopf 3 auch räumlich relativ weit auseinanderliegen und durch entsprechende Leitungen miteinander verbunden sein.

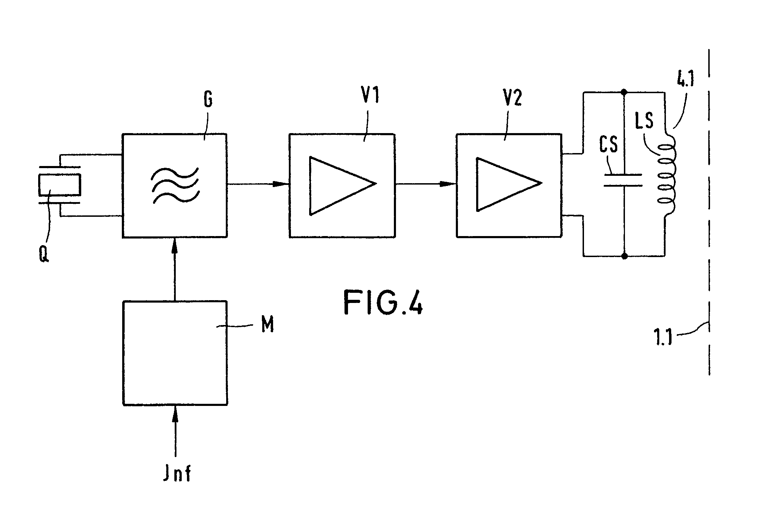

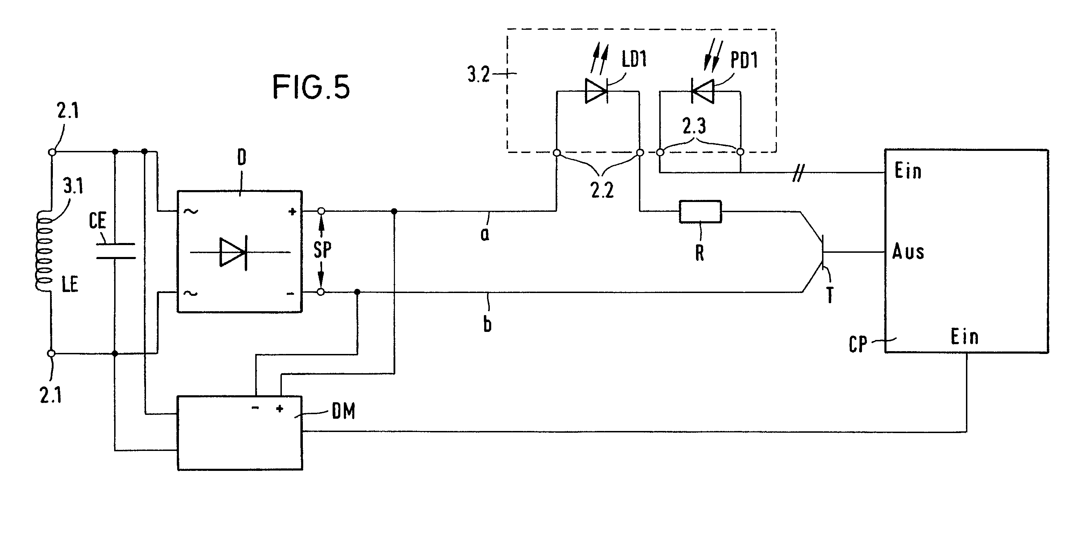

In den Fig. 4 und 5 ist eine Variante der oben beschriebenen Einrichtung dargestellt,mit der es möglich ist, Signale nicht nur auf dem optischen Signalweg, sondern in Richtung von der Ein-Auslesevorrichtung zum Datenspeicher zusätzliche Signale auf induktivem Wege zu übertragen.

Da es sich hier nur um geringfügige Änderungen handelt, sind in den Fig. 4 und 5 alle Einrichtungsteile, die der Ausführung nach Fig. 2 und 3 genau entsprechen, mit den gleichen Bezugszeichen versehen und werden im folgenden nicht mehr näher erläutert.

Die Ergänzung der Ausführungsform nach Fig. 2 und 3 besteht darin, daß in der Ein-Auslesevorrichtung dem Oszillator G ein Modulator M vorgeschaltet ist, dem über einen Eingang "Inf" die zusätzlichen Daten zugeführt werden, die vom Modulator M als Frequenzmodulation dem Ausgangssignal des Oszillators G aufgeprägt werden. In Fig. 4 ist im Unterschied zu Fig. 2 die Empfangsseite nicht dargestellt. Die Schaltungsteile auf der Empfangsseite sind Fig. 5 zu entnehmen. Wie man leicht erkennt, ist an den Schwingkreis LE-CE ein Demodulator DM angeschlossen, der seine Speisespannung von der Gleichspannungsseite des Gleichrichters D her erhält und dessen Ausgang mit einem weiteren Eingang des Mikrocomputers CP verbunden ist.

Die dem Hochfrequenzsignal in Form der Frequenzmodulation aufgeprägten Daten werden im Demodulator DM wiedergewonnen und dem Mikrocomputer CP zur Verarbeitung zugeführt.

Im dargestellten Ausführungsbeispiel erfolgt der auf induktivem Wege übertragene Datenverkehr nur einseitig, während der auf optischem Wege übertragene Datenverkehr zweiseitig verläuft. Es ist grundsätzlich auch möglich, den auf induktivem Wege übertragenen Datenverkehr zweiseitig auszugestalten. Hierzu müssen in nicht eigens dargestellter Weise lediglich sowohl im Sendekopf 3 als auch im Abtastkopf 4 zwei Spulen vorgesehen sein, die jeweils Teil eines Schwingkreises sind. Es sind dann jeweils zwei Paare von Schwingkreisen vorhanden, die auf unterschiedlichen Frequenzen arbeiten und von denen eines zur Energieübertragung und das andere zur Datenübertragung dient. Auf diese Weise ist es auch möglich, eine Einrichtung aufzubauen, mit der bei induktiver Energieübertragung von der Ein-Auslesevorrichtung her ein bidirektionaler Datenverkehr sowohl auf optischem als auch auf induktivem Wege möglich ist.

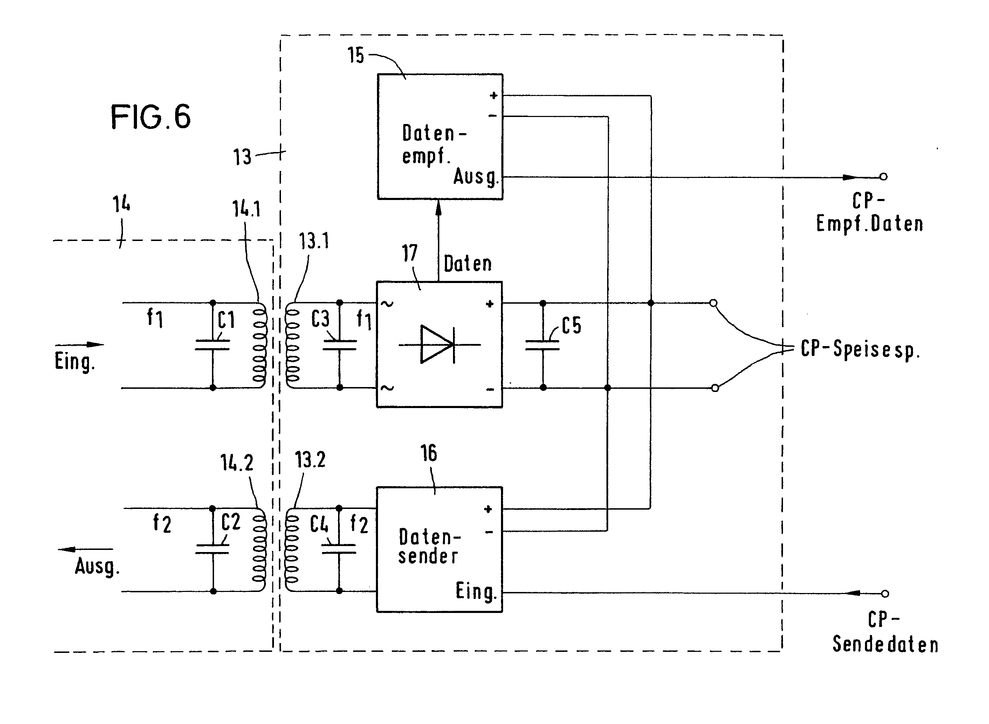

Im folgenden wird anhand der Fig. 6 bis 8 ein Ausführungsbeispiel beschrieben, bei dem sowohl die Energieübertragung als auch die Datenübertragung auf rein induktivem Wege erfolgen.

In Fig. 6 sind lediglich die Bauelemente dargestellt, die zum Verständnis dieser Ausführungsform notwendig sind. Ein induktiver Abtastkopf 14 ist bei dieser Ausführungsform in nicht dargestellter Weise, ähnlich wie der optische Abtastkopf 4 der vorbeschriebenen Ausführungsformen, über Verstärker an einen Sender angeschlossen, der ein Hochfrequenzsignal f1 abgibt, dem in Form einer Frequenzmodulation Daten aufgeprägt sind. Dieses Signal wird einer Induktionsspule 14.1 zugeführt, die zusammen mit einem Kondensator C1 Teil eines elektrischen Schwingkreises ist und im Abtastkopf 14 angeordnet ist. Weiterhin enthält der Abtastkopf 14 eine zweite Induktionsspule 14.2, die in nicht dargestellter Weise konzentrisch zur ersten Induktionsspule 14.1 angeordnet ist und zusammen mit einem Kondensator C2 Teil eines zweiten elektrischen Schwingkreises ist, der auf eine Frequenz f2 abgestimmt ist und in nicht dargestellter Weise über Verstärker mit einem Datenempfänger verbunden ist. Dieser Datenempfänger empfängt ein Hochfrequenzsignal mit der Frequenz f2, dem ebenfalls in Form einer Frequenzmodulation Daten aufgeprägt sind. Die beiden Frequenzen f1 und f2 sind unterschiedlich gewählt und können beispielsweise 32 kHz und 50 kHz betragen.

Ein in Fig. 6 ebenfalls nicht dargestellter Zähler, der in analoger Weise, wie bei den vorbeschriebenen Ausführungsbeispielen, einen mikroprozessorgesteuerten Datenspeicher aufweist, ist mit einem induktiven Sendekopf 13 verbunden, wobei die Schnittstelle zwischen dem induktiven Abtastkopf 14 und dein induktiven Sendekopf 13 durch räumliche Annäherung von Abtastkopf und Sendekopf zur Erzielung eines magnetischen Signalweges gebildet wird. Hierzu enthält der Sendekopf 13 eine erste Induktionsspule 13.1, die zusammen mit einem Kondensator C3 Teil eines auf die Frequenz f1 abgestimmten Schwingkreises bildet, der an einen Gleichrichter 17 angeschlossen ist, der an seinen Gleichspannungsausgängen ein durch einen Kondensator C5 geglättetes Gleichspannungssignal abgibt, das als Speisespannung (CP-SPEISESP.) dem Datenspeicher zugeführt wird. Weiterhin werden am Gleichrichter 17 die dem von der Induktionsspule 13.1 empfangenen Signal aufgeprägten Daten ausgekoppelt und einem Datenempfänger 15 zugeführt, der seine Speisespannung ebenfalls vom Gleichrichter 17 aus erhält. Der Datenausgang des Datenempfängers 15 ist mit einem Dateneingang (CP-EMPF.DATEN) des Datenspeichers verbunden.

Der Sendekopf 13 enthält eine zweite Induktionsspule 13.2, die zusammen mit einem Kondensator C4 Teil eines elektrischen Schwingkreises ist, der auf die Frequenz f2 abgestimmt ist und mit einem Datensender 16 verbunden ist, der seine Speisespannung vom Gleichrichter 17 aus erhält und dessen Dateneingang mit einem Datenausgang (CP-SENDEDATEN) des Datenspeichers verbunden ist.

Zum Auslesen von Daten wird der Abtastkopf 14 durch Ansetzen an eine entsprechende Stelle an einem Gehäuse (s. beispielsweise Fig. 1) gegenüber dem Sendekopf 13 so angeordnet, daß die Induktionsspulen 14.1 und 13.1 sowie 14.2 und 13.2 einander gegenüberliegen. Über das Hochfrequenzsignal mit der Frequenz f1 wird elektrische Energie zugeführt zur Erzeugung der Speisespannungen und zur Auslösung des Auslesevorgangs.

Hierzu werden die auszulesenden Daten dem Datensender 16 zugeführt und in einer Frequenzmodulation dem Hochfrequenzsignal mit der Frequenz f2 aufgeprägt, das dann über die Induktionsspulen 13.2 und 14.2 auf den Abtastkopf 14 übertragen und den Empfangseinrichtungen zugeführt wird. Sollen Daten in den Datenspeicher eingelesen werden oder Prüfvorgänge ausgelöst werden so dienen hierzu die gegebenenfalls dem Hochfrequenzsignal mit der Frequenz f1 aufgeprägten Daten, die über den Datenempfänger 15 dem Datenspeicher zugeführt werden.

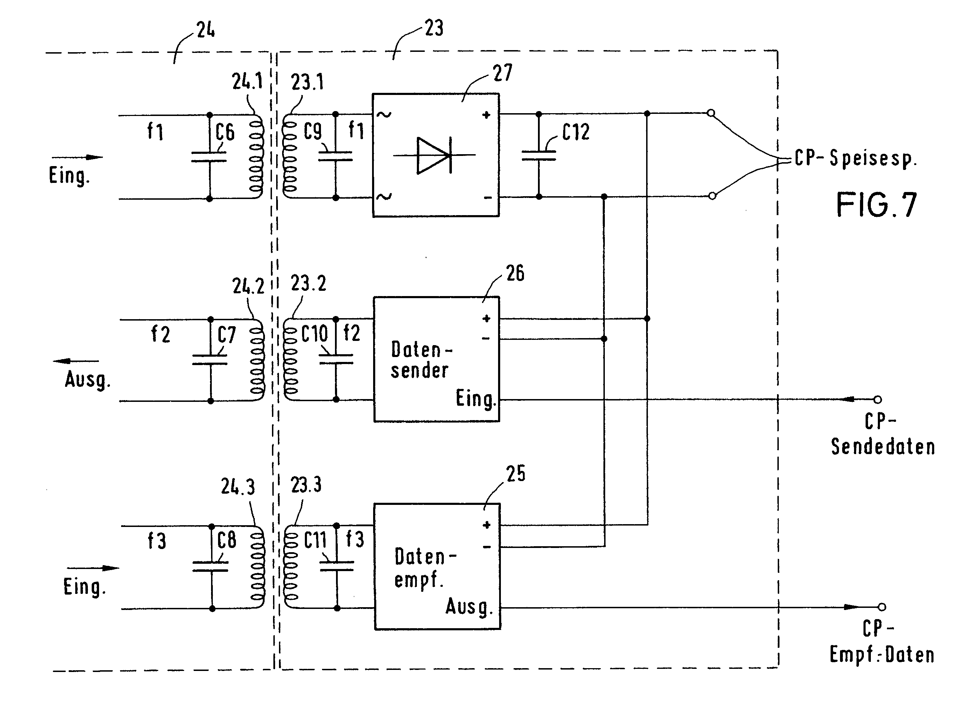

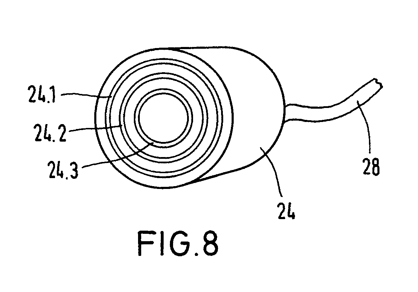

In Fig. 7 ist eine Variante der Ausführungsform nach Fig. 6 dargestellt, bei der das zur Zuführung der elektrischen Energie zur Erzeugung der Speisespannungen zugeführte Hochfrequenzsignal nicht zur Datenübertragung verwendet werden soll. Es wird dann mit drei Arbeitsfrequenzen f1, f2 und f3 gearbeitet. Der induktive Abtastkopf 24 enthält eine erste Induktionsspule 24.1, die zusammen mit dem Kondensator C6 Teil eines Schwingkreises mit der Frequenz f1 ist, eine zweite Induktionsspule 24.2, die zusammen mit dem Kondensator C7 Teil eines Schwingkreises mit der Frequenz f2 ist und eine dritte Induktionsspule 24.3, die mit dem Kondensator C8 Teil eines Schwingkreises mit der Frequenz f3 ist. Die Induktionsspulen 24.1, 24.2 und 24.3 können im Abtastkopf 24 so angeordnet sein wie dies in Fig. 8 dargestellt ist. Hier liegen die drei Induktionsspulen konzentrisch ineinander, wobei die äußerste Induktionsspule 24.1 zur Übertragung der elektrischen Energie dient, die zur Erzeugung der Speisespannung verwendet wird, während die beiden signalübertragenden Induktionsspulen 24.2 und 24.3 innerhalb dieser ersten Induktionsspule konzentrisch angeordnet sind. Über eine Kabelverbindung 28 ist der Abtastkopf 24 mit den bereits erwähnten Sende- und Empfangseinrichtungen verbunden.

Der Sendekopf 23 enthält eine erste Induktionsspule 23.1, die zusammen mit einem Kondensator C9 einen Schwingkreis mit der Frequenz f1 bildet, eine zweite Induktionsspule 23.2, die zusammen mit dem Kondensator C10 einen Schwingkreis mit der Frequenz f2 bildet und eine dritte Induktionsspule 23.3, die zusammen mit dem Kondensator C11 einen Schwingkreis mit der Frequenz f3 bildet. Die erste Induktionsspule 23.1 ist an einen Gleichrichter 27 angeschlossen, der an seinem Gleichspannungsausgang die durch einen Kondensator C12 geglättete Speisespannung abgibt, die einerseits dem nicht dargestellten Datenspeicher (CP-SPEISESP.) zugeführt wird und andererseits zur Versorgung eines Datensenders 26 und eines Datenempfängers 25 dient. Der Datensender 26 ist an die zweite Induktionsspule 23.2 und der Datenempfänger 25 an die dritte Induktionsspule 23.3 angeschlossen. Der Dateneingang des Datensenders 26 ist mit einem Datenausgang (CP-SENDEDATEN) des Datenspeichers verbunden, während der Datenausgang des Datenempfängers 25 mit einem Dateneingang (CP-EMPF.DATEN) des Datenspeichers verbunden ist.

Zum Aus- und Einlesen von Daten wird in der bereits mehrfach beschriebenen Weise der Abtastkopf 24 an den Sendekopf 23 angenähert und über die Induktionsspulen 24.1, 24.2, 24.3 und 23.1, 23.2, 23.3 die entsprechenden Signale zu- und abgeführt.

Auf diese Weise ist ein Duplex-Datenverkehr bei vollständiger Entkopplung von der Energiezuführung möglich.

**Patentansprüche**

1. Verfahren zum Auslesen und/oder Einlesen von Daten an einem mikroprozessorgesteuerten Datenspeicher, insbesondere eines registrierenden Meß- oder Zählgerätes, bei dem die Daten zwischen dem Datenspeicher und einer Ein/Auslesevorrichtung über eine Schnittstelle mit drahtloser Signalverbindung übertragen werden, dadurch gekennzeichnet, daß die zum Auslesen oder Ein lesen von Daten auf der Seite des Datenspeichers notwendige elektrische Energie von der Ein- Auslesevorrichtung aus über die Schnittstelle mit einer drahtlosen Energieverbindung zugeführt wird.

2. Verfahren nach Anspruch 1, dadurch gekennzeichnet, daß die Zuführung der elektrischen Energie mittels eines Hochfrequenzssignals auf induktivem Wege erfolgt.

3. Verfahren nach Anspruch 2, dadurch gekennzeichnet, daß die Frequenz des Hochfrequenzsignals einen Wert von 32,7 kHz hat.

4. Einrichtung zur Durchführung des Verfahrens nach Anspruch 2 oder 3 mit einer Ein- Auslesevorrichtung, die einen an elektronische Auswerte- und Eingabeeinheiten angeschlossenen optischen Abtastkopf mit optoelektronischen Wandlern zur Abgabe und Aufnahme von optischen Signalen aufweist, wobei der Datenspeicher mit einem entsprechenden optischen Sendekopf mit optoelektronischen Wandlern ausgerüstet ist und die Schnittstelle durch räumliche Annäherung von Abtastkopf und Sendekopf zur Erzielung eines optischen Signalweges gebildet wird, dadurch gekennzeichnet, daß am optischen Abtastkopf (4) eine Induktionsspule (4.1-LS) angeordnet ist, die Teil eines ersten der Ein- Auslesevorrichtung (4-6-7) zugeordneten elektrischen Schwingkreises (LS-CS) ist, der mit einem Sender (G) verbunden ist und am optischen Sendekopf (3) eine Induktionsspule (3.1-LE) angeordnet ist, die Teil eines zweiten dem Datenspeicher (CP) zugeordneten elektrischen Schwingkreises (LE-CE) ist, der über einen Gleichrichter (D) mit dem Speiseeingang (SP) einer Auslese- und/oder Einleseeinheit für den Datenspeicher (CP) verbunden ist, wobei die beiden Induktionsspulen (4.1, 3.1) derart ausgebildet und angeordnet sind, daß sie bei der räumlichen Annäherung von Abtastkopf (4) und Sendekopf (3) unmittelbar einander gegenüberliegen und die beiden Schwingkreise (LS-CS, LE-CE) auf die gleiche Frequenz abgestimmt sind.

5. Einrichtung nach Anspruch 4, dadurch gekennzeichnet, daß die Ausgangsklemmen (SP) des Gleichrichters (D) über eine Leiterschleife (a-b) miteinander verbunden sind, die den elektrooptronischen Wandler (LD1) des Sendekopfes (3.2) sowie einen Transistor (T) enthält, dessen Basis an den Signalausgang des Datenspeichers (CP) angeschlossen ist.

6. Einrichtung nach Anspruch 4 oder 5, dadurch gekennzeichnet, daß die beiden den gleichen Durchmesser besitzenden Induktionsspulen (4.1, 3.1) so ausgebildet und angeordnet sind, daß sie jeweils den optischen Abtastkopf (4) bzw. den optischen Sendekopf (3) umgeben.

7. Einrichtung nach Anspruch 6, dadurch gekennzeichnet, daß der Innendurchmesser der den optischen Abtastkopf (4) umgebenden Induktionsspule gleich dem Außendurchmesser des Abtastkopfes (4) ist und einen Wert von 25 bis 40 mm, insbesondere einen Wert von 32 mm aufweist.

8. Einrichtung zur Durchführung des Verfahrens nach Anspruch 2 mit einer Ein- Auslesevorrichtung, die einen an elektronische Auswerte- und Eingabeeinheiten angeschlossenen induktiven Abtastkopf (14, 24) zur Abgabe und Aufnahme von magnetischen Signalen aufweist, wobei der Datenspeicher mit einem entsprechenden induktiven Sendekopf (13, 23) ausgerüstet ist und die Schnittstelle durch räumliche Annäherung von Abtastkopf und Sendekopf zur Erzielung eines magnetischen Signalweges gebildet wird, dadurch gekennzeichnet, daß am induktiven Abtastkopf (14, 24) mindestens eine Induktionsspule (14.1, 14,2; 24.1, 24.2, 24.3) angeordnet ist, die Teil eines ersten der Ein- Auslesevorrichtung zugeordneten elektrischen Schwingkreises ist, der mit einem Sender verbunden ist und am induktiven Sendekopf (13, 23) mindestens eine Induktionsspule (13.1, 13.2; 23.1, 23.2, 23.3) angeordnet ist, die Teil eines zweiten dem Datenspeicher zugeordneten elektrischen Schwingkreises ist, der über einen Gleichrichter (17, 27) mit dem Speiseeingang einer Auslese- und/oder Einleseeinheit für Datenspeicher verbunden ist, wobei die beiden Induktionsspulen derart ausgebildet und angeordnet sind, daß sie bei der räumlichen Annäherung von Abtastkopf und Sendekopf unmittelbar einander gegenüberliegen und die beiden Schwingkreise auf die gleiche Frequenz abgestimmt sind.

9.  Einrichtung nach Anspruch 4 oder 8, dadurch gekennzeichnet, daß der erste Schwingkreis (14.1) zusätzlich mit den elektrischen Auswerte- und Eingabeeinheiten der Ein-Auslesevorrichtung und der zweite Schwingkreis (13.1) zusätzlich mit dem Signaleingang der Auslese- und/oder Einleseeinheit für den Datenspeicher verbunden ist.

10. Einrichtung nach Anspruch 8, dadurch gekennzeichnet, daß der induktive Abtastkopf (24) und der induktive Sendekopf (23) jeweils eine besondere zur Energieübertragung dienende Induktionsspule (24.1, 23.1) aufweisen, wobei die beiden den gleichen Durchmesser besitzenden Induktionsspulen so ausgebildet und angeordnet sind, daß sie jeweils den induktiven Abtastkopf (24) bzw. den induktiven Sendekopf (23) umgeben.

11. Einrichtung nach Anspruch 4 oder 8, dadurch gekennzeichnet, daß dem Sender (G) ein Modulator (M) zur Erzeugung eines modulierten Hochfrequenzsignals zur Datenübertragung zugeordnet ist und an den zweiten Schwingkreis (LE-CE) ein Demodulator (DM) zum Empfang der Daten angeschlossen ist.

FIG.1

FIG.2

FIG.3

EP 0 457 306 A2

FIG.4

FIG.5

EP 0 457 306 A2

**FIG.6**

EP 0 457 306 A2

FIG.7

EP 0 457 306 A2

FIG.8